# EUROPEAN PATENT APPLICATION

(11) **EP 2 528 106 A1**
(43) Date of publication of application: **28.11.2012**
(21) Application number: 11830822.0
(22) Date of filing: 27.04.2011
(51) Int. Cl.: H01L 31/042

(54) **PHOTOVOLTAIC POWER GENERATION DEVICE AND MANUFACTURING METHOD THEREOF**

(30) Priority: 05.10.2010 KR 20100097057
(71) Applicant: LG Innotek Co., Ltd., Seoul 100-714 (KR)
(72) Inventor: LEE, Jinwoo, Seoul 100-714 (KR)
(74) Representative: Bethenod, Marc
(86) International application number: PCT/KR2011/003126
(87) International publication number: WO 2012/046936

(57) **Abstract**

Provided are a photovoltaic power generating apparatus and a method of manufacturing the apparatus. The photovoltaic power generating apparatus includes a substrate, a first backside electrode, a second backside electrode, and a separator. The first backside electrode is disposed on the substrate. The second backside electrode is disposed on the substrate and is spaced apart from the first backside electrode. The separator is disposed between the first backside electrode and the second backside electrode.

## Description

### [Technical Field]

The present disclosure relates to a photovoltaic power generating apparatus and a method of manufacturing the apparatus.

### [Background Art]

As the demand for energy increases, photovoltaic power generating apparatuses for converting solar radiation into electrical energy are actively developed.

Particularly, copper-indium-gallium-selenide (CIGS) photovoltaic power generating apparatuses as p-n heterojunction apparatuses are widely used, which include a glass substrate, a metal backside electrode layer, a p-type CIGS based light absorbing layer, a high resistance buffer layer, and an n-type window layer.

To manufacture such a photovoltaic power generating apparatus, a patterning process for forming a plurality of separate cells is needed.

### [Disclosure]

### [Technical Problem]

Embodiments provide a photovoltaic power generating apparatus, which prevents a short circuit and has improved photoelectric conversion efficiency.

### [Technical Solution]

In one embodiment, a photovoltaic power generating apparatus includes: a substrate; a first backside electrode on the substrate; a second backside electrode disposed on the substrate and spaced apart from the first backside electrode; and a separator disposed between the first backside electrode and the second backside electrode.

In another embodiment, a photovoltaic power generating apparatus includes: a substrate; a plurality of separators on the substrate; and a plurality of backside electrodes each disposed between the separators.

In another embodiment, a method of manufacturing a photovoltaic power generating apparatus includes: forming a plurality of sacrificial separators on a substrate; forming each of backside electrodes between the sacrificial separators on the substrate; forming a plurality of light absorbers on the backside electrodes; partially removing the sacrificial separators; and forming a window layer on the sacrificial separators and the light absorbers.

The details of one or more embodiments are set forth in the accompanying drawings and the description below. Other features will be apparent from the description and drawings, and from the claims.

### [Advantageous Effects]

Since the photovoltaic power generating apparatus according to the embodiment includes the separators between the backside electrodes, a short circuit can be prevented from being formed between the backside electrodes. Thus, photoelectric conversion efficiency of the photovoltaic power generating apparatus according to the embodiment can be improved.

In the method of manufacturing the photovoltaic power generating apparatus according to the embodiment, the backside electrodes are automatically separated by the sacrificial separators formed in advance.

Thus, in the method of manufacturing the photovoltaic power generating apparatus according to the embodiment, the backside electrodes can be formed without patterning a conductive layer.

Thus, the photovoltaic power generating apparatus can be efficiently manufactured using the manufacturing method according to the embodiment.

### [Description of Drawings]

Fig. 1 is a plan view illustrating a solar cell panel according to a first embodiment.
Fig. 2 is a cross-sectional view taken along line A-A' of Fig. 1.
Figs. 3 to 10 are cross-sectional views illustrating a method of manufacturing the solar cell panel according to the first embodiment.
Fig. 11 is a cross-sectional view illustrating a solar cell panel according to a second embodiment.
Figs. 12 to 16 are cross-sectional views illustrating a method of manufacturing the solar cell panel according to the second embodiment.
Fig. 17 is a cross-sectional view illustrating a solar cell panel according to a third embodiment.
Figs. 18 to 21 are cross-sectional views illustrating a method of manufacturing the solar cell panel according to the third embodiment.

### [Mode for Invention]

Reference will now be made in detail to the embodiments of the present disclosure, examples of which are illustrated in the accompanying drawings. The spirit and scope of the present disclosure, however, shall not be construed as being limited to embodiments provided herein. Rather, it will be apparent that other embodiments that fall within the spirit and scope of the present disclosure may easily be derived through adding, modifying, and deleting elements herein.

In the descriptions of embodiments, it will be understood that when a substrate, a layer (or film), a region, a pattern, or an electrode is referred to as being 'on/under' a substrate, a layer (or film), a region, a pattern, or an electrode, it can be directly on/under the substrate, the layer (or film), the region, the pattern, or the electrode, or intervening components may also be present. Further, the reference about 'on' and 'under' each component layer will be made on the basis of drawings. In addition, the sizes of elements and the relative sizes between elements may be exaggerated for further understanding of the present disclosure.

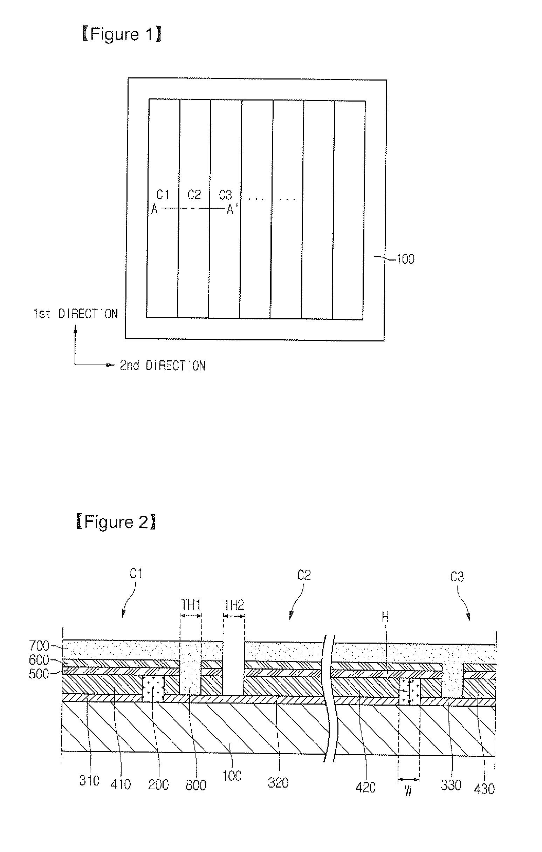

Fig. 1 is a plan view illustrating a solar cell panel according to a first embodiment. Fig. 2 is a cross-sectional view taken along line A-A' of Fig. 1.

Referring to Figs. 1 and 2, the solar cell panel includes a support substrate 100, a plurality of separators 200, a plurality of backside electrodes 310, 320, and 330, a plurality of light absorbers 410, 420, and 430, a buffer layer 500, a high resistance buffer layer 600, a window layer 700, and a plurality of connectors 800.

The support substrate 100 has a plate shape, and supports the separators 200, the backside electrodes 310, 320, and 330, the light absorbers 410, 420, and 430, the buffer layer 500, and the high resistance buffer layer 600, the window layer 700, and the connectors 800.

The support substrate 100 may be an electrical insulator. The support substrate 100 may be a glass substrate, a plastic substrate, or a metal substrate. In more detail, the support substrate 100 may be a soda lime glass substrate. The support substrate 100 may be transparent. The support substrate 100 may be rigid or flexible.

The separators 200 are disposed on the support substrate 100. The separators 200 contact the top surface of the support substrate 100. In more detail, the separators 200 may be integrally formed with the support substrate 100.

The separators 200 extend in a first direction. In more detail, the separators 200 may have a bar shape extending in the first direction. The separators 200 may be parallel to and spaced apart from each other.

The separators 200 are electrical insulators. For example, the separators 200 may be formed of silicon oxide (SiO₂).

The separators 200 may have a width to electrically insulate the backside electrodes 310, 320, and 330 from each other. For example, the separators 200 may have a width ranging from about 10 µm to about 200 µm.

The separators 200 may have a height H corresponding to the level of the top surface of the light absorbers 410, 420, and 430. That is, the height H of the separators 200 may correspond to the sum of the thickness of the light absorbers 410, 420, and 430, and the thickness of the backside electrodes 310, 320, and 330. For example, the height H of the separators 200 may range from about 1 µm to about 3 µm.

The backside electrodes 310, 320, and 330 are disposed on the support substrate 100. The backside electrodes 310, 320, and 330 may directly contact the top surface of the support substrate 100. A separate layer may be disposed between a plurality of the backside electrodes 310, 320, and 330, and a plurality of the support substrate 100.

Each of the backside electrodes 310, 320, and 330 is disposed between the separators 200. That is, a plurality of the backside electrodes 310, 320, and 330, and a plurality of the separators 200 may be alternately arrayed. For example, one separator is disposed between the backside electrode 310 of a first cell C1 and the backside electrode 320 of a second cell C2. One backside electrode is disposed between two separators.

Side surfaces of the backside electrodes 310, 320, and 330 may directly contact side surfaces of the separators 200.

The backside electrodes 310, 320, and 330 are spaced apart from one another by the separators 200. That is, the separators 200 are disposed between the backside electrodes 310, 320, and 330 to space the backside electrodes 310, 320, and 330 apart from one another. That is, the separators 200 separate the backside electrodes 310, 320, and 330 from one another.

The backside electrodes 310, 320, and 330 are electrical conductors. For example, the backside electrodes 310, 320, and 330 may be formed of a metal such as molybdenum. The backside electrodes 310, 320, and 330 may include two or more layers. In this case, the two or more layers may be formed of the same metal or different metals. The backside electrodes 310, 320, and 330 may be arrayed in a stripe or matrix shape.

The light absorbers 410, 420, and 430 are disposed on the backside electrodes 310, 320, and 330. In more detail, the light absorbers 410, 420, and 430 are disposed on the backside electrodes 310, 320, and 330, respectively. The light absorbers 410, 420, and 430 may directly contact the top surfaces of the backside electrodes 310, 320, and 330.

The light absorbers 410, 420, and 430 are disposed between the separators 200. In more detail, a plurality of the light absorbers 410, 420, and 430, and a plurality of the separators 200 are arrayed alternately. Side surfaces of the light absorbers 410, 420, and 430 may directly contact the side surfaces of the separators 200.

The light absorbers 410, 420, and 430 include p-type semiconductor compounds. In more detail, the light absorbers 410, 420, and 430 include a group I-III-VI based compound. For example, the light absorbers 410, 420, and 430 may have a copper-indium-gallium-selenide based (Cu(In,Ga)Se₂; CIGS based) crystal structure, a copper-indium-selenide based crystal structure, or a copper-gallium-selenide based crystal structure.

The light absorbers 410, 420, and 430 may have an energy band gap ranging from about 1 eV to about 1.8 eV.

The buffer layer 500 is disposed on the light absorbers 410, 420, and 430. In more detail, the buffer layer 500 may cover the light absorbers 410, 420, and 430, and the separators 200. The buffer layer 500 may include cadmium sulfide (CdS), and has an energy band gap ranging from about 2.2 eV to about 2.4 eV.

The high resistance buffer layer 600 is disposed on the buffer layer 500. The high resistance buffer layer 600 includes zinc oxide (i-ZnO) undoped with an impurity. The high resistance buffer layer 600 has an energy band gap ranging from about 3.1 eV to about 3.3 eV.

First through recesses TH1 are disposed in the light absorbers 410, 420, and 430, the buffer layer 500, and the high resistance buffer layer 600. The first through recesses TH1 pass through the light absorbers 410, 420, and 430. The first through recesses TH1 are open regions exposing the top surfaces of the backside electrodes 310, 320, and 330.

The first through recesses TH1 are adjacent to the separators 200. That is, the first through recesses TH1 are next to the separators 200 from a plan view. The first through recesses TH1 extend in the first direction.

The first through recesses TH1 may have a width ranging from about 80 µm to about 200 µm.

The buffer layer 500 is defined as a plurality of buffers by the first through recesses TH1. That is, the buffer layer 500 is divided into a plurality of buffers by the first through recesses TH1.

The high resistance buffer layer 600 is defined as a plurality of high resistance buffers by the first through recesses TH1. That is, the high resistance buffer layer 600 is divided into a plurality of high resistance buffers by the first through recesses TH1.

The window layer 700 is disposed on the high resistance buffer layer 600. That is, the window layer 700 is disposed on the light absorbers 410, 420, and 430, and the separators 200. The window layer 700 covers the light absorbers 410, 420, and 430, and the separators 200.

The window layer 700 is a transparent electrical conductive layer. The resistance of the window layer 700 is higher than that of the backside electrodes 310, 320, and 330. The window layer 700 is an n-type window layer.

The window layer 700 includes an oxide. For example, the window layer 700 may include Al doped zinc oxide (AZO) or Ga doped zinc oxide (GZO).

Second through recesses TH2 are disposed in the light absorbers 410, 420, and 430, the buffer layer 500, the high resistance buffer layer 600, and the window layer 700. The second through recesses TH2 pass through the light absorbers 410, 420, and 430, the buffer layer 500, the high resistance buffer layer 600, and the window layer 700.

The second through recesses TH2 are adjacent to the first through recesses TH1. In other words, the second through recesses TH2 are next to the first through recesses TH1. That is, from a plan view, the second through recesses TH2 are parallel to the first through recesses TH1. The second through recesses TH2 may extend in the first direction.

The second through recesses TH2 pass through the window layer 700. Accordingly, the window layer 700 is divided into a plurality of windows. In this case, the windows cover the separators 200, respectively.

The windows have a shape corresponding to the backside electrodes 310, 320, and 330. That is, the windows are arrayed in a stripe shape. Alternatively, the windows may be arrayed in a matrix shape.

The cells C1, C2, and C3 are defined by the second through recesses TH2. In more detail, the cells C1, C2, and C3 are defined by the first through recesses TH1 and the second through recesses TH2. That is, the solar cell panel according to the current embodiment, as a photovoltaic power generating apparatus, includes the cells C1, C2, and C3 divided by the first through recesses TH1 and the second through recesses TH2. The cells C1, C2, and C3 are connected to each other in a second direction crossing the first direction. That is, an electrical current flows in the second direction through the cells C1, C2, and C3.

The connectors 800 are disposed in the first through recesses TH1. The connectors 800 extend downward from the window layer 700, and are connected to the backside electrodes 310, 320, and 330, respectively. For example, the connector 800 extends from the window of the first cell C1, and connects to the backside electrode 320 of the second cell C2.

Thus, the connectors 800 connect neighboring cells to each other. In more detail, the connectors 800 connect the windows and the backside electrodes 310, 320, and 330 of the cells C1, C2, and C3 to each other.

The connectors 800 are integrally formed with the window layer 700. That is, the connectors 800 and the window layer 700 are formed of the same material.

Since the backside electrodes 310, 320, and 330 are separated from one another by the separators 200, a short circuit is prevented from being formed between the backside electrodes 310, 320, and 330. That is, instead of the semiconductor compound constituting the light absorbers 410, 420, and 430, the separators 200 as electrical insulators are disposed between the backside electrodes 310, 320, and 330, thereby to more efficiently insulate the backside electrodes 310, 320, and 330 from one another.

Since the separators 200, as electrical insulators, more efficiently insulate the backside electrodes 310, 320, and 330 from one another, the distance between the backside electrodes 310, 320, and 330 can be reduced.

Accordingly, the area of an effective region for converting solar radiation into electrical energy can be increased.

Thus, a short circuit can be prevented in the solar cell panel according to the current embodiment, and electrical characteristics of the panel can be improved.

In addition, photoelectric conversion efficiency of the panel can be improved.

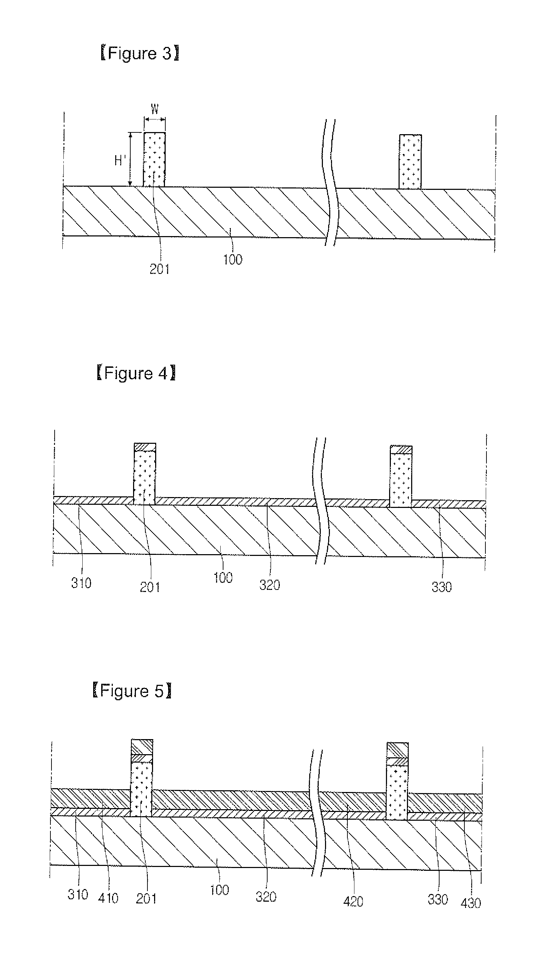

Figs. 3 to 10 are cross-sectional views illustrating a method of manufacturing the solar cell panel according to the first embodiment. A description of this manufacturing method refers to the description of the above-described photovoltaic power generating apparatus. The previous description of the photovoltaic power generating apparatus may be coupled to the description of the manufacturing method.

Referring to Fig. 3, a plurality of sacrificial separators 201 are formed on the support substrate 100. The sacrificial separators 201 contact the top surface of the support substrate 100. The sacrificial separators 201 may be integrally formed with the support substrate 100.

The sacrificial separators 201 are electrical insulators, and may be formed of glass or plastic.

The sacrificial separators 201 may have a width W ranging from about 10 µm to about 200 µm. The sacrificial separators 201 may have a height H' ranging from about 10 µm to about 500 µm. In more detail, the height H' of the sacrificial separators 201 may range from about 20 µm to about 30 µm.

Referring to Fig. 4, a metal such as molybdenum is deposited on the support substrate 100. Accordingly, the backside electrodes 310, 320, and 330 are formed on the support substrate 100.

That is, the deposited metal is automatically patterned by the sacrificial separators 201, and thus, the backside electrodes 310, 320, and 330 are disposed between the sacrificial separators 201. The backside electrodes 310, 320, and 330 may include two or more layers formed under different process conditions.

As such, the backside electrodes 310, 320, and 330 are formed by automatically patterning the deposited metal using the sacrificial separators 201. Thus, the backside electrodes 310, 320, and 330 can be formed without a complicated process such as laser patterning.

Referring to Fig. 5, the light absorbers 410, 420, and 430 are formed on the backside electrodes 310, 320, and 330. The light absorbers 410, 420, and 430 may be formed using a sputtering process or an evaporation method.

For example, to form the light absorbers 410, 420, and 430, a layer of a copper-indium-gallium-selenide based (Cu(In,Ga)Se₂; CIGS based) semiconductor compound may be formed by simultaneously or separately evaporating copper, indium, gallium, and selenium. Alternatively, a metal precursor film forming process and a selenization process may be sequentially performed to form the light absorbers 410, 420, and 430.

In more detail, a metal precursor film is formed on the backside electrodes 310, 320, and 330 through a sputtering process using a copper target, an indium target, and a gallium target.

Then, a layer of a copper-indium-gallium-selenide based (Cu(In,Ga)Se₂; CIGS based) semiconductor compound is formed through a selenization process using the metal precursor film.

Alternatively, the sputtering process using a copper target, an indium target, and a gallium target, and the selenization process may be simultaneously performed.

Alternatively, a sputtering process using a copper target and an indium target or using a copper target and a gallium target, and a selenization process may be performed to form a layer of a CIS or CIG based semiconductor compound.

A semiconductor compound layer formed as described above is automatically patterned by the sacrificial separators 201, and thus, the light absorbers 410, 420, and 430 are formed between the sacrificial separators 201.

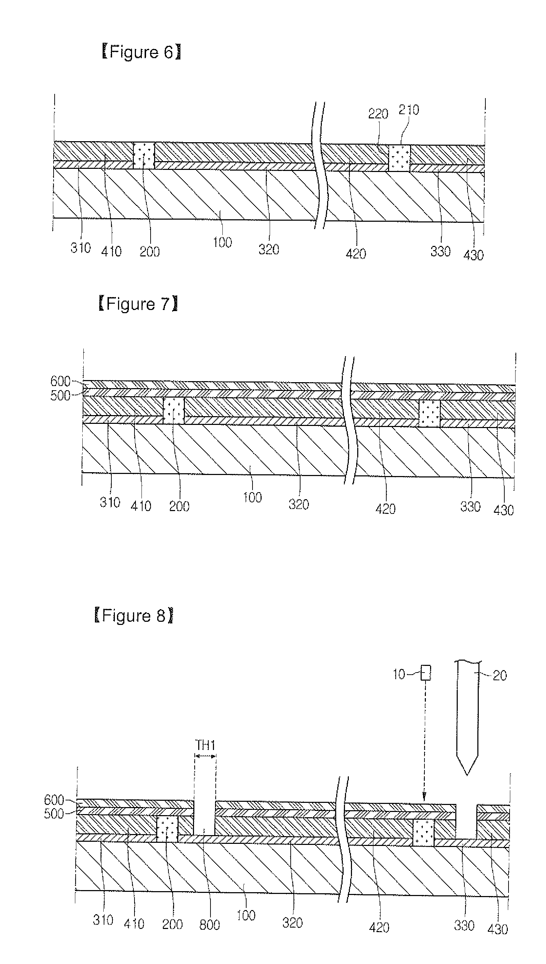

Referring to Fig. 6, the upper portions of the sacrificial separators 201 are cut out to form the separators 200 on the support substrate 100. The sacrificial separators 201 may be mechanically cut out. In this case, top surfaces 210 of the separators 200 may be mechanically cut surfaces. That is, the roughness of the top surfaces 210 may be larger than that of the side surfaces of the separators 200.

The top surfaces 210 of the separators 200 may be flush with the top surfaces of the light absorbers 410, 420, and 430. Thus, the height of the separators 200 corresponds to the sum of the thickness of the light absorbers 410, 420, and 430 and the thickness of the backside electrodes 310, 320, and 330.

Referring to Fig. 7, cadmium sulfide is deposited using a sputtering process or a chemical bath deposition (CBD) method to form the buffer layer 500 on the light absorbers 410, 420, and 430, and the separators 200.

Then, zinc oxide is deposited on the buffer layer 500 through a sputtering process to form the high resistance buffer layer 600.

The buffer layer 500 and the high resistance buffer layer 600 have small thicknesses. For example, the buffer layer 500 and the high resistance buffer layer 600 may have a thickness ranging from about 1 nm to about 80 nm.

Referring to Fig. 8, the light absorbers 410, 420, and 430, the buffer layer 500, and the high resistance buffer layer 600 are partially removed to form the first through recesses TH1.

The positions of the first through recesses TH1 are determined using the separators 200 as references. For example, the positions of the separators 200 may be sensed using an optical sensor 10. The buffer layer 500 and the high resistance buffer layer 600 are very thin, and have high transmissivity. Thus, the optical sensor 10 can sense the position of the separators 200 by emitting light to the light absorbers 410, 420, and 430, and the separators 200.

After that, a patterning device 20 such as a tip may be aligned to be spaced a predetermined distance from the separators 200 to form the first through recesses TH1.

The first through recesses TH1 may be formed using a mechanical device such as a tip, or a laser device.

For example, the light absorbers 410, 420, and 430, and the buffer layer 500 may be patterned using a tip having a width ranging from about 40 µm to about 180 µm.

In this case, the first through recesses TH1 may have a width ranging from about 100 µm to about 200 µm. The first through recesses TH1 partially expose the top surfaces of the backside electrodes 310, 320, and 330.

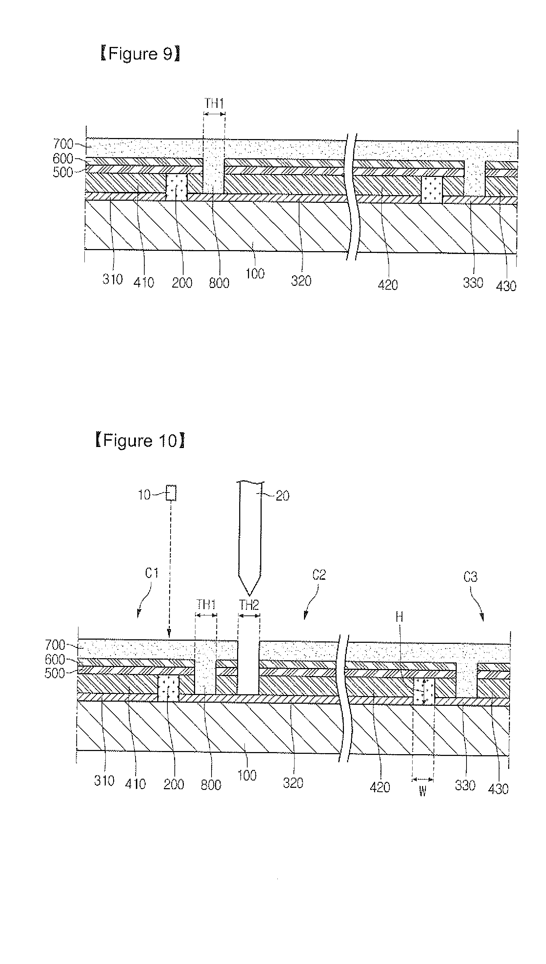

Referring to Fig. 9, the window layer 700 is formed on the light absorbers 410, 420, and 430 and in the inner spaces of the first through recesses TH1. That is, the window layer 700 is formed by depositing a transparent electrical conducting material on the high resistance buffer layer 600 and in the inner spaces of the first through recesses TH1.

For example, the window layer 700 may be formed by depositing Al doped zinc oxide through a sputtering process on the top surface of the high resistance buffer layer 600 and in the inner spaces of the first through recesses TH1.

At this point, the first through recesses TH1 are filled with the transparent electrical conducting material, and the window layer 700 directly contacts the backside electrodes 310, 320, and 330.

Referring to Fig. 10, the light absorbers 410, 420, and 430, the buffer layer 500, the high resistance buffer layer 600, and the window layer 700 may be patterned through a mechanical scribing process. Accordingly, the second through recesses TH2 adjacent to the first through recesses TH1 are formed.

The positions of the second through recesses TH2 are determined using the separators 200 as references. For example, the positions of the separators 200 may be sensed using the optical sensor 10. The buffer layer 500 and the high resistance buffer layer 600 are very thin, and the window layer 700 has high transmissivity. Thus, the optical sensor 10 can sense the position of the separators 200 by emitting light to the light absorbers 410, 420, and 430, and the separators 200.

After that, the patterning device 20 such as a tip may be aligned to be spaced a predetermined distance from the separators 200 to form the second through recesses TH2.

A plurality of windows and the cells C1, C2, and C3 are defined on the window layer 700 by the second through recesses TH2. The second through recesses TH2 may have a width ranging from about 80 µm to about 200 µm.

As such, the backside electrodes 310, 320, and 330 can be efficiently formed without a laser process.

Thus, the solar cell panel can be efficiently manufactured using the above manufacturing method.

In addition, the solar cell panel manufactured according to the manufacturing method has improved photoelectric conversion efficiency, and a short circuit can be prevented between the backside electrodes 310, 320, and 330.

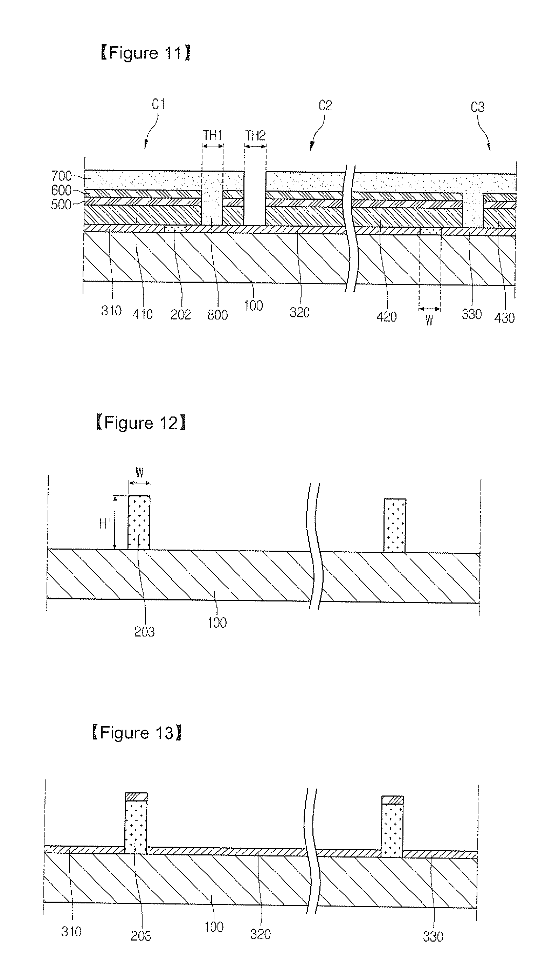

Fig. 11 is a cross-sectional view illustrating a solar cell panel according to a second embodiment. The current embodiment refers to the above described solar cell panel and the method of manufacturing the solar cell panel. That is, the description of the previous embodiment may be coupled to a description of the current embodiment except for different parts.

Referring to Fig. 11, a plurality of separators 202 are disposed between the backside electrodes 310, 320, and 330. The top surfaces of the separators 202 may be flush with the top surfaces of the backside electrodes 310, 320, and 330. The height of the separators 202 may be substantially the same as that of the backside electrodes 310, 320, and 330.

The light absorbers 410, 420, and 430 may cover the separators 202. That is, the light absorbers 410, 420, and 430 directly contact the top surface of the separators 202.

Since the top surfaces of the separators 202 may be flush with the top surfaces of the backside electrodes 310, 320, and 330, the light absorbers 410, 420, and 430 can be efficiently formed on the backside electrodes 310, 320, and 330, and the separators 202. That is, since the light absorbers 410, 420, and 430 are formed on a plane without an uneven surface, defects of the light absorbers 410, 420, and 430 can be reduced.

Thus, the performance of the solar cell panel according to the current embodiment can be improved.

Figs. 12 to 16 are cross-sectional views illustrating a method of manufacturing the solar cell panel according to the second embodiment. This method refers to the above solar cell panels and the manufacturing method according to the previous embodiment. That is, the description of the above solar cell panels and the manufacturing method according to the previous embodiment may be coupled to a description of the manufacturing method according to the current embodiment, except for different parts.

Referring to Fig. 12, a plurality of sacrificial separators 203 are formed on the support substrate 100.

Referring to Fig. 13, a metal such as molybdenum is deposited on the support substrate 100. Accordingly, the backside electrodes 310, 320, and 330 are formed on the support substrate 100.

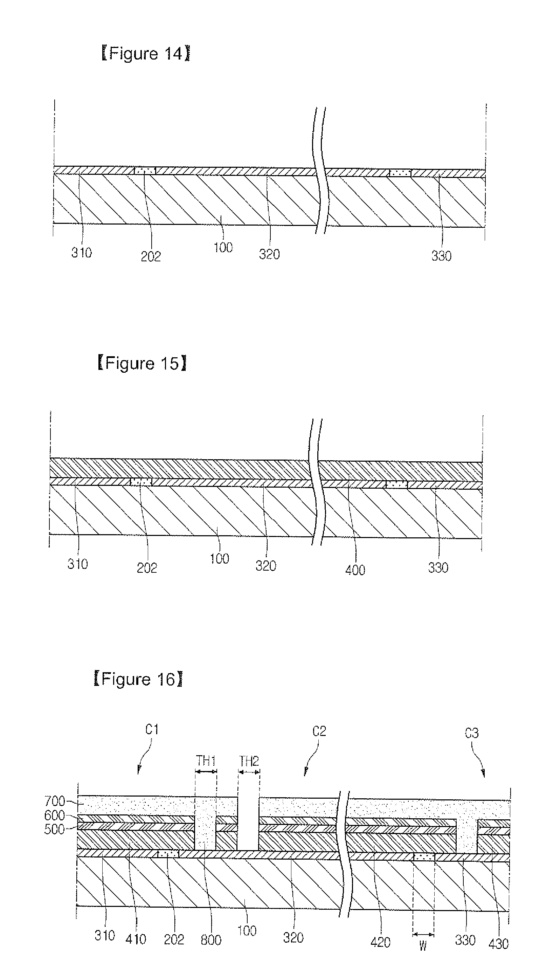

Referring to Fig. 14, the upper portions of the sacrificial separators 203 are cut out to form the separators 202 on the support substrate 100. Since the backside electrodes 310, 320, and 330 include a metal such as molybdenum, the backside electrodes 310, 320, and 330 are securely attached to the support substrate 100. The backside electrodes 310, 320, and 330 are resistant to a mechanical shock and other damages.

Thus, the upper portions of the sacrificial separators 203 can be efficiently cut out.

Referring to Fig. 15, a light absorbing layer 400 is formed on the separators 202 and the backside electrodes 310, 320, and 330. The light absorbing layer 400 may be formed using a sputtering process or an evaporation method.

Referring to Fig. 16, the buffer layer 500 and the high resistance buffer layer 600 are sequentially formed on the light absorbing layer 400. Then, the first through recesses TH1 are formed in the light absorbing layer 400, the buffer layer 500, and the high resistance buffer layer 600. Accordingly, the light absorbing layer 400 is divided into the light absorbers 410, 420, and 430.

Then, the window layer 700 is formed on the high resistance buffer layer 600, and the second through recesses TH2 are formed in the light absorbing layer 400, the buffer layer 500, the high resistance buffer layer 600, and the window layer 700. Accordingly, a plurality of separate cells are formed.

As described above, after the backside electrodes 310, 320, and 330 are formed, the sacrificial separators 203 are cut out. Accordingly, damage occurring during the cutting of the sacrificial separators 203 can be minimized. That is, since a process of cutting the sacrificial separators 203 is performed before a process of forming the light absorbing layer 400, damage to the light absorbing layer 400 can be minimized.

Furthermore, the light absorbing layer 400 is formed on even surfaces of the sacrificial separators 203 and the backside electrodes 310, 320, and 330. Thus, the method of manufacturing the solar cell panel makes it possible to minimize defects of the light absorbing layer 400.

As such, the solar cell panel manufactured the method has improved performance.

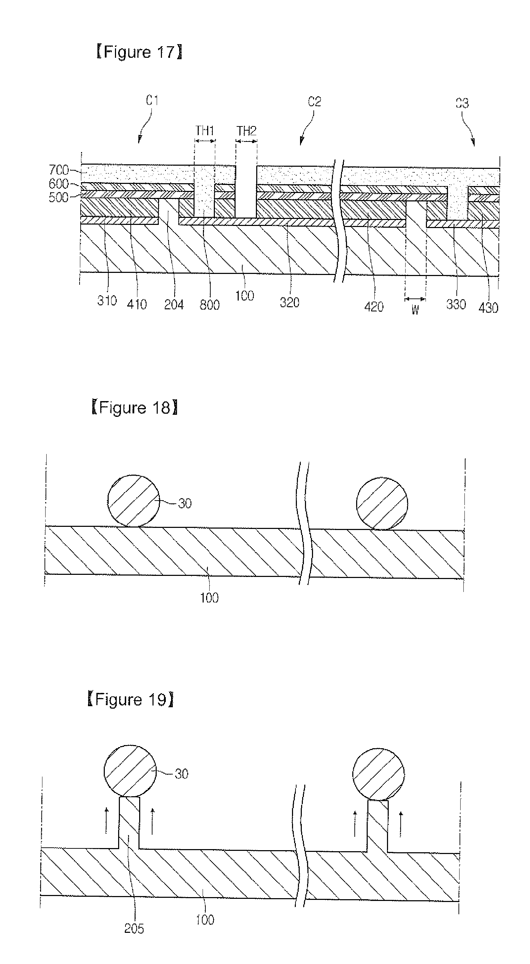

Fig. 17 is a cross-sectional view illustrating a solar cell panel according to a third embodiment. Figs. 18 to 21 are cross-sectional views illustrating a method of manufacturing the solar cell panel according to the third embodiment. The solar cell panel and the method of manufacturing the solar cell panel according to the current embodiment refer to the solar cell panels and the methods of manufacturing the solar cell according to the previous embodiments. That is, the descriptions of the previous embodiments may be coupled to a description of the current embodiment except for different parts.

Referring to Fig. 17, separators 204 may be integrally formed with the support substrate 100. That is, the separators 204 and the support substrate 100 may be formed of the same material, as a single body.

The support substrate 100 may be a soda lime glass substrate including sodium. The separators 204 may also include sodium. That is, the separators 204 may be formed of soda lime glass.

Accordingly, the sodium constituting the support substrate 100 and the separators 204 can be efficiently transferred to the light absorbing layer 400.

Thus, the solar cell panel according to the current embodiment can have improved performance, and be efficiently manufactured.

The method of manufacturing the solar cell panel according to the current embodiment will now be described.

Referring to Fig. 18, heating wires 30 are disposed on the support substrate 100. The heating wires 30 extend in the first direction. Then, contacts between the support substrate 100 and the heating wires 30, and regions surrounding the contacts are heated by the heating wires 30. Accordingly, the support substrate 100 is partially molten.

Referring to Fig. 19, the heating wires 30 rise from the support substrate 100. Accordingly, the molten contacts and the molten regions surrounding the contacts also rise. After that, the molten contacts and the molten regions are cooled, and sacrificial separators 205 are integrally formed with the support substrate 100.

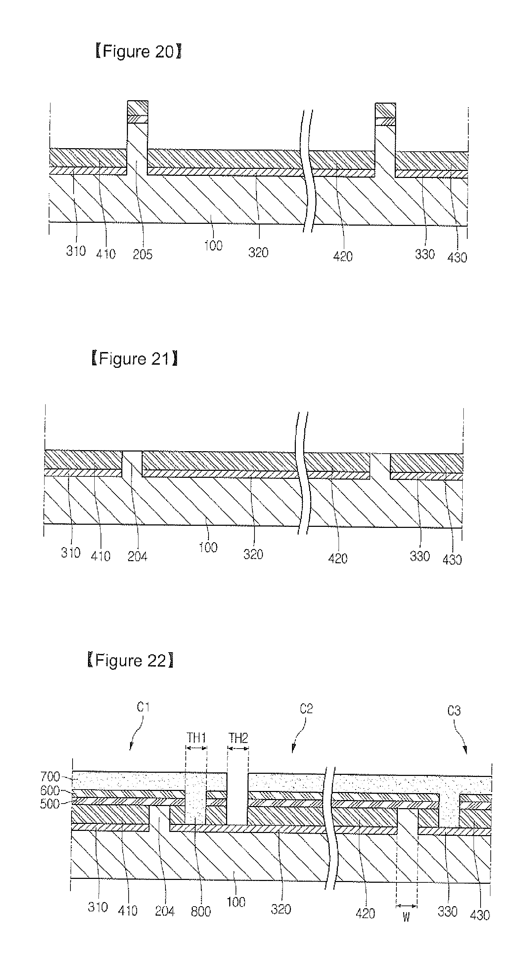

Referring to Fig. 20, a metal such as molybdenum is deposited on the support substrate 100 to form the backside electrodes 310, 320, and 330. The backside electrodes 310, 320, and 330 are automatically formed in a pattern by the sacrificial separators 205.

Then, a group I-III-VI based semiconductor compound is deposited on the backside electrodes 310, 320, and 330, and the light absorbers 410, 420, and 430 are formed thereon. The light absorbers 410, 420, and 430 are automatically formed in a pattern by the sacrificial separators 205.

Referring to Fig. 21, the upper portions of the sacrificial separators 205 are cut out to form the separators 204.

Referring to Fig. 22, the buffer layer 500 and the high resistance buffer layer 600 are sequentially formed on the light absorbers 410, 420, and 430, and the first through recesses TH1 are formed in the light absorbers 410, 420, and 430, the buffer layer 500, and the high resistance buffer layer 600.

Then, the window layer 700 is formed on the high resistance buffer layer 600, and the second through recesses TH2 are formed in the light absorbers 410, 420, and 430, the buffer layer 500, the high resistance buffer layer 600, and the window layer 700.

As such, the sacrificial separators 205 can be efficiently formed by the heating wires 30. Thus, the solar cell panel efficiently manufactured using the manufacturing method according to the current embodiment has improved performance.

The solar cell panels according to the above embodiments are photovoltaic power generating apparatuses for converting solar radiation into electrical energy. That is, the structures according to the above embodiments may be modified for application to a different type of photovoltaic power generating apparatuses.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### [Industrial Applicability]

The photovoltaic power generating apparatus and the method of manufacturing the same according to the embodiments are used in the field of photovoltaic power generation.

## Claims

1. A photovoltaic power generating apparatus comprising:
a substrate;
a first backside electrode on the substrate;
a second backside electrode disposed on the substrate and spaced apart from the first backside electrode; and
a separator disposed between the first backside electrode and the second backside electrode.

2. The apparatus according to claim 1, comprising:
a first light absorber on the first backside electrode; and
a second light absorber on the second backside electrode,
wherein the separator is disposed between the first light absorber and the second light absorber.

3. The apparatus according to claim 2, wherein the separator directly contacts a side surface of the first light absorber and a side surface of the second light absorber.

4. The apparatus according to claim 2, comprising a first window on the first light absorber,
wherein the first window covers the separator.

5. The apparatus according to claim 1, wherein a first light absorber covers the separator.

6. The apparatus according to claim 1, wherein the separator comprises silicon oxide.

7. The apparatus according to claim 1, wherein the separator is integrally formed with the substrate.

8. A photovoltaic power generating apparatus comprising:
a substrate;
a plurality of separators on the substrate; and
a plurality of backside electrodes each disposed between the separators.

9. The apparatus according to claim 8, comprising a plurality of light absorbers each disposed between the separators on the backside electrodes.

10. The apparatus according to claim 9, comprising a plurality of windows on the light absorbers,
wherein the windows cover the separators, respectively.

11. The apparatus according to claim 8, wherein roughness of top surfaces of the separators is larger than roughness of side surfaces of the separators.

12. The apparatus according to claim 8, wherein the separators are integrally formed with the substrate.

13. A method of manufacturing a photovoltaic power generating apparatus, the method comprising:
forming a plurality of sacrificial separators on a substrate;
forming each of backside electrodes between the sacrificial separators on the substrate;
forming a plurality of light absorbers on the backside electrodes;
partially removing the sacrificial separators; and
forming a window layer on the sacrificial separators and the light absorbers.

14. The method according to claim 13, wherein the forming of the light absorbers is followed by the removing of the sacrificial separators.

15. The method according to claim 13, wherein the sacrificial separators have a height ranging from about 20 µm to about 30 µm.

16. The method according to claim 13, wherein the forming of the sacrificial separators comprises:
partially heating the substrate; and
partially raising the heated substrate.

17. The method according to claim 13, wherein the forming of the light absorbers comprises:
forming a light absorbing layer on the backside electrodes; and
forming a through recess adjacent to the sacrificial separator and disposed in the light absorbing layer.

18. The method according to claim 17, wherein the forming of the through recess comprises determining a position of the through recess using the sacrificial separator as a reference.

19. The method according to claim 13, comprising forming a through recess in the window layer,
wherein a position of the through recess is determined using the sacrificial separator as a reference.
